# EUROPEAN PATENT SPECIFICATION

(11) **EP 3 961 831 B1**
(45) Date of publication and mention of the grant of the patent: **11.09.2024**
(21) Application number: 20193177.1
(22) Date of filing: 27.08.2020
(51) Int. Cl.: H02B 1/052, H05K 7/14, H02B 1/16

(54) **RETENTION MECHANISM FOR ATTACHMENT OF A TECHNICAL EQUIPMENT UNIT TO A MOUNTING RAIL AS WELL AS TECHNICAL EQUIPMENT UNIT WITH SUCH A RETENTION MECHANISM**
HALTEMECHANISMUS ZUR BEFESTIGUNG EINER TECHNISCHEN AUSRÜSTUNGSEINHEIT AUF EINER MONTAGESCHIENE SOWIE TECHNISCHE AUSRÜSTUNGSEINHEIT MIT EINEM SOLCHEN HALTEMECHANISMUS
MÉCANISME DE RETENUE POUR LA FIXATION D'UNE UNITÉ D'ÉQUIPEMENT TECHNIQUE SUR UN RAIL DE MONTAGE ET UNITÉ D'ÉQUIPEMENT TECHNIQUE DOTÉ D'UN TEL MÉCANISME DE RETENUE

(43) Date of publication of application: 02.03.2022
(73) Proprietor: TE Connectivity Germany GmbH, 64625 Bensheim (DE)
(72) Inventor: OFENLOCH, Markus, 68642 Bürstadt (DE); ABOULKASSEM, Mohamed, 64347 Griesheim (DE); ZIMMER, Frank, 64283 Darmstadt (DE); KREUTZ, Friedhelm, 55118 Mainz (DE)
(74) Representative: Grünecker Patent- und Rechtsanwälte PartG mbB

(56) References cited:
- GB-A- 2 381 132
- US-A1- 2017 338 649
- US-B1- 9 276 333
- US-B2- 7 516 927

## Description

### Technical field to which the invention relates

The present invention relates to a retention mechanism for attachment of a technical equipment unit, such as a PCB module or a circuit breaker, to a mounting rail e.g., a DIN rail. Further, the present invention relates to a technical equipment unit with such a retention mechanism.

### Background art

In the field of electrical engineering and in other technological fields, certain units of technical equipment are installed in so-called equipment racks. Equipment racks serve the purpose inter alia of protecting these technical equipment units from environmental impact as well as organizing them in a structured manner. In order to achieve optimal and efficient organization, the respective technical equipment units can be attached and lined up on internal rails of the equipment racks.

Generally, the internal rails of a standardized mounting rail type are used. Therefore, predefined means can be employed for the attachment of the respective technical equipment unit thereto.

US 9,276,333 B1 relates to a rail-engaging structure including a slidable engaging member, a pivotable hook member and an elastic member. The engaging member and hook member are connected at their respective ends via a flexible thin wall or pivot pins, while receiving an elastic force of the elastic member. US 7,516,927 B2 shows a rail attachment device with a slidable plate and rotatable rods inside a casing of an electrical apparatus. An intermediate part connected to the plate and rods is configured to convert a translation movement of the plate into a rotary movement of the rods. Thus, the plate and rods are movable between an unlocked position and a locked position. GB 2 381 132 A discloses a telecommunications connector with a base part configured for attachment to an earth rail. Integrally formed lugs enable the base part to engage with the rail. At least one resilient beam with a hook at its free end is provided in order to cater for rails of differing sizes. US 2017/0338649 A1 relates to a modular distribution block for a high-current power system including a ground module. The ground module includes a metal grounding clamp configured to electrically and mechanically connect to a DIN rail and to retain the distribution block on the DIN rail.

Existing attachment means, however, often contain a complex mechanism involving a multitude of cooperating components and are thus usually prone to damage or malfunction. Attachment means including mechanisms with a low number of components on the other hand tend to be limited in their functionality, especially with regard to the attachment and detachment processes.

Therefore, it is desirable to have attachment means for attaching technical equipment units to mounting rails, which comprise only a minimal amount of components, while providing high functionality.

### Technical object to be achieved

The object of the present invention is to provide improved attachment means for attaching a technical equipment unit to a mounting rail with a simple yet highly functional mechanism.

### Disclosure of invention

The object is achieved by providing a retention mechanism for attachment of a technical equipment unit to a mounting rail, the retention mechanism comprising a slider, which is movable in a translational manner along a sliding direction, a frame enclosing a groove for guiding the translational movement of the slider, and a lever, which is pivotable about a pivoting axis, wherein the lever is mechanically coupled with the slider, wherein the slider comprises a first retention section and the lever comprises a second retention section aligned with the first retention section in the sliding direction, and wherein a reception area for receiving the mounting rail is defined between the first retention section and the second retention section, wherein the frame is electrically conductive, and wherein the frame comprises at least one first contact point extending into the reception area and at least one second contact point extending away from the reception area.

It is to be understood that the technical equipment unit may be a PCB module, a circuit breaker or any other type of electrical or electronic unit or equipment as well as mechanical gear as by example but not exclusively separators or wire organization elements, which requires attachment to a mounting rail. It is further to be understood that the mounting rail may be, without limiting it to, a DIN rail, in particular a DIN rail with a hat-shaped cross section according to DIN EN 60715. Moreover, it is to be understood that the reception area is for receiving for example a length section of the mounting rail.

The functionality of the above-proposed retention mechanism benefits from the utilization of two components with different movement characteristics, especially from the combination of a translational and a pivotal movement. This is beneficial to the dynamic behaviour of the retention mechanism, compared to e.g., a mechanism combining two translationally movable components. Even if guaranteeing a static retention, dynamic loads can be compensated by the inventive mechanism.

Furthermore, a synchronization of said movements is achieved by the mechanical coupling between the lever and slider. This facilitates the attachment process as well as the detachment process, since it is sufficient to move actively only one of the slider and lever during these processes. The definition of a reception area further simplifies these processes and allows the implementation of proposedly specification-defined mechanical interface suitable e.g. for DIN 60715 7.5 TH 35 /7.5 without limiting the application thereto.

The above solution may be further improved by adding one or more of the following optional features. Each optional feature is advantageous on its own and may be combined independently with any other optional feature.

According to one possible embodiment of the retention mechanism, the first retention section of the slider may be formed by a first hook or hook-shaped projection extending away from the rest of the slider. Correspondingly, the second retention section of the lever may be formed by a second hook or hook-shaped projection extending away from the rest of the lever. The first hook and the second hook represent easy to manufacture means for gripping the mounting rail received in the reception area.

According to another possible embodiment of the retention mechanism, the mechanical coupling between the lever and the slider may be achieved through a mechanical joint, such as, for example a linking element or a non-rigid component. The mechanical joint may connect end sections of the lever and slider, respectively, in order to transfer forces and transmit motions therebetween. Preferably, the end sections of the lever and slider, which are connected by the mechanical joint, are distal from the first hook and second hook, respectively.

To achieve the mechanical coupling between the lever and slider without the use of additional components, such as additional joint elements, the lever may be directly coupled with the slider. In particular, the end section of the lever may be inserted between two inner walls of a cavity formed in the end section of the slider. The two inner walls are preferably arranged opposite to each other in the sliding direction. Preferably, the two inner walls may be arranged opposite to each other along the sliding direction. Thus, a movement of the slider in the sliding direction causes one of the two inner walls to abut against the inserted end section of the lever, thereby transferring the corresponding force of the slider onto the lever. A reverse movement of the slider against the sliding direction causes the other, opposite of the two inner walls to abut against the inserted end section of the lever. Thereby, the reverse force is transferred, respectively.

Optionally, the two inner walls may be curved in a circumferential direction with respect to the pivoting axis. This facilitates the force transfer between the slider and lever.

According to another embodiment, the slider may be movable into a slider locking position and/or the lever may be movable into a lever locking position. Further, the slider may be movable into a slider release position and/or the lever may be movable into a lever release position. Preferably, the reception area is narrower when the slider and/or lever is in the respective locking position (i.e. slider locking position and/or lever locking position), and wider when the slider and/or lever is in the respective release position (i.e. slider release position and/or lever release position). In particular, a clear width of the reception area measured parallel to the sliding direction is smaller than a width of the mounting rail when the slider and/or lever is in the respective locking position. Accordingly, when the slider and/or lever is in the respective release position, the clear width of the reception area is equal to or larger than the width of the mounting rail. Thus, the mounting rail can be engaged by or released from the first retention section and the second retention section according to the respective positions of the slider and/or lever. This will be further described in detail below. The slider and/or the lever may be retained in its locking position, its release position or both its locking and its release position.

Further, the slider may preferably be movable between the slider locking position and the slider release position. In addition, the lever may be preferably movable between the lever locking position and the lever release position. More preferably still, the lever moves into the lever release position when the slider is moved into the slider release position, and vice versa. The same may apply to the respective locking positions. Thereby, the slider and lever may be adapted to simultaneously engage and release the mounting rail, respectively.

According to another possible embodiment of the retention mechanism, the first retention section may comprise a first engagement surface extending in the sliding direction and parallel to the pivoting axis. The second retention section may comprise a second engagement surface, wherein the first engagement surface and the second engagement surface are mutually coplanar when the slider is in the slider locking position and the lever is in the lever locking position. In particular, the second engagement surface may extend e.g. in a tangential direction with respect to an imaginary cylinder around the pivoting axis. The two coplanar engagement surfaces each provide a resting surface for the mounting rail. For example, outwardly extending flanges of the mounting rail may rest on and be stably supported by the respective engagement surfaces.

According to another possible embodiment of the retention mechanism, the first retention section may comprise a first latching protrusion extending towards the second retention section. The second retention section may comprise a second latching protrusion extending towards the first retention section. In this embodiment, the mounting rail may be gripped by the respective latching protrusions, which extend towards each other. In particular, the first latching protrusion may protrude into the reception area when the slider is in the slider locking position. The second latching protrusion may protrude into the reception area when the lever is in the lever locking position. The first latching protrusion may just clear the reception area when the slider is moved into the slider release position. Accordingly, the second latching protrusion may just clear the reception area when the lever is moved into the lever release position.

The terms "just clear" should be understood to refer to a state of the first and second protrusion, in which the corresponding protrusion is exactly on the verge of protruding into the reception area without actually protruding into the reception area. In other words, the slightest movement of the slider and/or lever from the respective release position towards the reception area would cause the corresponding protrusion to at least partially protrude into the reception area.

Preferably, the first engagement surface is formed on the first latching protrusion. Accordingly, the second engagement surface may be formed on the second latching protrusion. Thus, the first engagement surface and/or the second engagement surface may be positioned in the reception area for the purpose of attaching the technical equipment unit to the mounting rail via the retention mechanism. Analogously, the first engagement surface and/or the second engagement surface may be moved out of the reception area for the purpose of detaching the technical equipment unit from the mounting rail via the retention mechanism.

For increased stability, the pivoting axis of the lever may be held fixedly and rotatably within the retention mechanism. Further, the pivoting axis may extend perpendicularly to the sliding direction.

The reception area may be adapted to receive the mounting rail along a preferential rail mounting direction. The mounting direction may be defined with respect to the sliding direction and the direction of the pivoting axis. The definition of a preferential rail mounting direction allows the design of the retention mechanism to be optimized according to the expected relative movement between the mounting rail and the respective components of the retention mechanism during the attachment process as well as the detachment process of the technical equipment unit.

Optionally, the preferential rail mounting direction may be indicated e.g., by at least one arrow symbol. The at least one arrow symbol may be printed, stamped, stuck, engraved or otherwise marked on the retention mechanism and/or the technical equipment unit. This is especially helpful during the attachment process.

According to another possible embodiment, the rail mounting direction may extend linearly i.e., straight, towards a plane spanned by the sliding direction and the pivoting axis. Preferably, the rail mounting direction is perpendicular to the sliding direction. Also preferably, the rail mounting direction is perpendicular to the pivoting axis. Thus, in combination with the aforementioned simultaneous engagement and release of the mounting rail, the attachment process as well as the detachment process of the technical equipment unit can take place along a straight path of movement at least in immediate proximity of the mounting rail. The attachment process and detachment process can, especially, take place without the need to tilt the technical equipment unit relative to the mounting rail. This is advantageous for applications e.g., with limited installation space or other types of spatial constrains.

In order to support the outwardly extending edges of the mounting rail stably from the rail mounting direction, the first engagement surface and the second engagement surface may face in the rail mounting direction when the slider and lever are in their respective locking positions.

According to yet another possible embodiment of the retention mechanism, at least one of the first retention section and second retention section may comprise a bevel surface extending obliquely with respect to the rail mounting direction, wherein each bevel surface forms a lead-in chamfer. In particular, each lead-in chamfer extends through the reception area, especially, through a peripheral zone of the reception area.

If the bevel surface is comprised by the first retention section, the bevel surface may be aligned with the first engagement surface in the rail mounting direction. Accordingly, the bevel surface may be aligned with the second engagement surface in the rail mounting direction if the bevel surface is comprised by the second retention section.

By providing such a bevel surface on at least one of the first retention section and second retention section, the retention mechanism can be easily latched onto the mounting rail during the attachment process of the technical equipment unit. In detail, the technical equipment unit may be pushed onto the mounting rail, such that the mounting rail enters into the reception area, in particular into the peripheral zone of the reception area. Thereupon, one of the outwardly extending flanges of the mounting rail can abut against the bevel surface at or near an outer edge of the bevel surface. By further pushing the technical equipment unit onto the mounting rail, the mechanically coupled slider and lever are gradually pressed out of their respective locking positions and towards their respective release positions. Once the outwardly extending flange, which abuts against the bevel surface, passes an inner edge of the bevel surface, the slider and lever may return into their respective locking positions. Consequently, the outwardly extending flange, which abutted against the bevel surface, as well as the corresponding other outwardly extending flange of the mounting rail are positioned beyond the first engagement surface and second engagement surface.

In order to balance the load during the aforementioned "clip on" process, both the first retention section and the second retention section may comprise a bevel surface extending obliquely with respect to the rail mounting direction and forming lead-in chamfers, respectively. In particular, the first retention section may comprise a first bevel surface and the second retention section may comprise a second bevel surface. Preferably, the first bevel surface is formed on the first latching protrusion and the second bevel surface is formed on the second latching protrusion. More preferably still, the first bevel surface is positioned opposite of the first engagement surface on the first latching protrusion and the second bevel surface is positioned opposite of the second engagement surface on the second latching protrusion with respect to the rail mounting direction, respectively.

According to another possible embodiment, the retention mechanism may comprise a position restoration element, which exerts a force on at least one of the slider and lever. In particular, the position restoration element may be a resilient element such as a coil spring. Accordingly, the force may be an elastic force. Preferably, the force may be directed towards the reception area. More preferably still, the force may act parallel to the sliding direction. Additionally or alternatively, the force may act along the pivoting direction of the lever. As such, the position restoration element may aid the "clip on" process described above, by automatically returning the slider and lever from their respective release positions to their respective locking positions once the mounting rail's outwardly extending flanges, which abutted against the bevel surfaces, have passed the inner edges of the bevel surfaces, respectively.

Preferably, the groove extends at least partially in the sliding direction. The movement of the slider may thus be guided in the groove. Moreover, the lever may be pivotably held in the groove. The position restoration element may be fixedly held in the groove.

By providing the retention mechanism with a frame, it is possible to create a preassembled module, which can be readily assembled to a unit housing of the technical equipment unit. In particular, the preassembled module may be received in a receptacle formed in the unit housing, as will be further described in detail below.

Optionally, the frame may comprise at least one guiding slot extending parallel to the groove in the sliding direction. For each guiding slot, the slider may comprise at least one sliding block or rib protruding into the respective guiding slot. In another embodiment, the frame may comprise at least one sliding block or rib and the slider may comprise at least one guiding slot. A width of the at least one guiding slot measured perpendicularly to the sliding direction may be equal to or larger than a width of the corresponding sliding block measured perpendicularly to the sliding direction. A length of the at least one guiding slot measured parallel to the sliding direction may be larger than a length of the corresponding sliding block measured parallel to the sliding direction. The length of the at least one guiding slot may be equal to or larger than a traveling distance of the slider moving between the slider locking position and the slider release position. Preferably, the length of the at least one guiding slot is equal to or larger than the sum of the length of the corresponding sliding block and the traveling distance of the slider moving between the slider locking position and the slider release position.

Optionally, the frame may further comprise at least one fixing hole extending parallel to the pivoting axis. Preferably, the frame comprises two fixing holes at opposite sides of the groove. For each fixing hole, the lever may comprise at least one axle pin projecting into the respective fixing hole. All axle pins of the lever may be aligned in the direction of the pivoting axis. Alternatively, the frame may comprise at least one axle pin and the lever may comprise at least one corresponding fixing hole.

According to yet another embodiment, the frame may have a lateral recess. In particular, the lateral recess may be a cut-out in the frame. The lateral recess may be substantially cuboid and may extend along the sliding direction and/or the rail mounting direction and/or parallel to the pivoting axis. The lateral recess may in particular extend at least partially into the groove. Preferably, the lateral recess at least partially coincides with the reception area. Thus, the lateral recess can clearly and visibly designate the reception area for the benefit of a simplified attachment process.

Preferably, the lateral recess makes the slider and lever accessible e.g., to the mounting rail. In particular, the first latching protrusion of the slider may protrude into the lateral recess of the frame when the slider is in the slider locking position. The second latching protrusion of the lever may protrude into the lateral recess when the lever is in the lever locking position. The first latching protrusion may just clear the lateral recess when the slider is moved into the slider release position. Accordingly, the second latching protrusion may just clear the lateral recess when the lever is moved into the lever release position.

In particular, the frame may be made of metal, such as aluminium, copper or stainless steel. Besides the improved mechanical stability gained from such a material choice, the frame may also be utilized for discharging interference currents or fault currents.

In particular, the at least one first contact point may be formed by at least one elastic spring finger extending into the lateral recess of the frame. The first contact point may electrically contact the metallic mounting rail received therein.

It is to be understood that the term metallic mounting rail refers to a mounting rail being completely made out of metal or at least having one of a metal coating and plating. Mounting rails being otherwise provided with electrical conductivity are also compatible with this embodiment.

In particular, the at least one second contact point may be formed by at least one elastic spring finger extending away from the lateral recess of the frame. Preferably, the at least one second contact point extends inside of the technical equipment unit and electrically contacts an electrical component, such as a printed circuit board (PCB), of the technical equipment unit. Thus, a grounding function can be fulfilled by the frame without the use of additional components, such as an electrically conductive grounding clip connecting the electrical component e.g., PCB, of the technical equipment unit to the mounting rail. The first and second contact point may, for example, be shaped as a prong.

In order to save material costs, the frame may alternatively be made of a material with no or low electrical conductivity, such as a resin. If a grounding function is required, an electrically conductive grounding clip comprising the at least one first contact point and the at least one second contact point may be fastened to the frame and connect the electrical component e.g., PCB, of the technical equipment unit to the mounting rail instead.

According to another embodiment, the retention mechanism may comprise at least one arresting feature with at least one abutment surface for securing the slider, the lever, or both the slider and the lever against movement. The at least one arresting feature may be formed on the slider and/or the lever. With the help of the at least one arresting feature, an unwanted, unintended or unauthorized movement of the slider and lever can be selectively prevented. The arresting feature may also be referred to as a latch or holding element.

For example, the at least one arresting feature may secure the slider and lever in their respective locking positions. Thereby, unintended removal of the retention mechanism from the mounting rail can be prevented.

According to another embodiment, the at least one arresting feature may secure the slider in a slider end position, which is situated away from the slider locking position and beyond the slider release position. Preferably, a traveling distance of the slider moving between the slider locking position and the slider end position equals the length of the at least one guiding slot of the frame subtracted by the length of the corresponding sliding block of the slider. Accordingly, the at least one arresting feature may secure the lever in a lever end position, which is situated away from the lever locking position and beyond the lever release position.

This embodiment is especially advantageous for applications where spatial constrains do not allow the technical equipment unit to be pushed onto the mounting rail, thereby rendering the "clip on" process described above impracticable. Under such circumstances, the at least one arresting feature can be utilized to secure the slider and lever in their respective end positions in preparation of the attachment process. As the end positions are situated beyond the release positions and away from the locking positions, the mounting rail may be received in the reception area without coming into contact with the slider or lever. Consequently, the technical equipment unit can be placed on the mounting rail smoothly and without requiring any pushing movement.

Once the technical unit is placed on the mounting rail, the slider and lever may be brought into their respective locking positions. To allow this movement of the slider and lever, the at least one arresting feature may be transferable from a securing state to a disengaging state. In particular, the at least one arresting feature may be movable, tiltable, slidable and/or deflectable from the securing state to the disengaging state. In the securing state, the at least one arresting feature secures the slider and lever against movement, as described above. In the disengaging state, the at least one arresting feature releases the slider and lever, thus allowing movement of the slider and lever.

Upon transferring the at least one arresting feature from the securing state to the disengaging state, the position restoration element may take effect and automatically return the slider and lever to their respective locking positions, thereby attaching the technical equipment unit to the mounting rail via the retention mechanism, as described above.

Analogously, the at least one arresting feature may be transferable from the disengaging state to the securing state. Preferably, this transfer takes place automatically when at least one of the slider and lever is moved into their respective end positions, whereupon the slider and lever are then secured by the at least one arresting feature.

By securing the slider and lever in their respective end positions, beyond their respective release positions, it is ensured that the transfer of the at least one arresting feature from the disengaging state to the securing state does not take place unintendedly e.g., during the "clip on" process described above, since the slider and lever are only brought into their respective release positions, but not therebeyond, in the course of the "clip on" process.

According to one possible embodiment, the at least one arresting feature may exhibit a shoulder, which engages with an edge of a counterpart arresting feature. The counterpart arresting feature may be formed on the frame or inside of the unit housing. Preferably, the shoulder is pivotable into and out of alignment with the edge of the counterpart arresting feature, the alignment being co-linear to the sliding direction. In particular, the shoulder may be monolithically connected to the rest of the slider and/or lever via a torsion hinge. Further, the torsion hinge may bias the shoulder towards the alignment with the edge of the counterpart arresting feature.

In this embodiment, the torsion hinge represents an easy to manufacture means for providing the shoulder's ability to be pivoted into and out of alignment with the edge of the counterpart arresting feature, while also biasing the shoulder towards the alignment with the edge of the counterpart arresting feature. Alternatively, any kind of hinge or bearing providing the shoulder with the ability to be pivoted into and out of alignment with the edge of the counterpart arresting feature is applicable. Optionally, the shoulder may also be spring-loaded and/or biased towards the alignment of the edge of the counterpart arresting feature by other resilient means.

Optionally, a release button may be arranged on an opposite side of the torsion hinge. Thus, when the release button is pressed in a circumferential direction with respect to the torsion hinge, the shoulder can be leveraged out of alignment with the edge of the counterpart arresting feature. This represents a means for effortlessly transferring the at least one arresting feature from the securing state to the disengaging state. Preferably, the release button is only operable with a tool e.g., a screwdriver. Alternatively, the release button may also be operable with a finger.

Further, optionally, a skew surface may be provided on the same side of the torsion hinge as the shoulder. Preferably, the skew surface abuts against the edge of the counterpart arresting feature when the slider is moved from the slider locking position to the slider end position. Also, the skew surface preferably extends obliquely with respect to the sliding direction. Furthermore, the abutment between the skew surface and the edge of the counterpart arresting feature preferably causes the shoulder to be gradually leveraged out of alignment with the edge of the counterpart arresting feature during the course of the slider's movement from the slider locking position to the slider end position. Preferably still, the shoulder is brought back into alignment with the edge of the counterpart arresting feature, once the slider reaches the slider end position. Thereby, a bistable click mechanism can be realized, which automatically transfers the at least one arresting feature from the disengaging state to the securing state when the slider is moved into the slider end position.

The initial object is further achieved by a technical equipment unit comprising a retention mechanism according to any one of the above-explained embodiments and a unit housing, wherein the unit housing has a receptacle for receiving the retention mechanism. The technical equipment unit may be a functional and/or electronics compound.

This technical equipment unit is advantageous, since it adopts the above explained features and advantages of the inventive retention mechanism. In particular, the technical equipment unit comprises a simple yet highly functional retention mechanism for attachment to the mounting rail.

If the retention mechanism comprises the frame (i.e. modular embodiment), the resulting preassembled module may be assembled to the unit housing. In particular, the frame may comprise latching features for establishing latching connections with counterpart latching features formed in the receptacle of the unit housing. Additionally or alternatively, the frame may comprise connectors for establishing connections via adequate interfaces formed in the receptacle of the unit housing. Preferably, the frame may comprise a combination of latching features and plugging features. In this case, it is preferred to establish the connections first, by pushing the frame at an angle into the receptacle. Thereafter, the latching connections may be established by swivelling the angled frame into the receptacle and bringing the latching features into engagement with the counterpart latching features. This way, the retention mechanism and the unit housing can be brought easily into their assembled state.

According to one possible embodiment of the technical equipment unit, at least one of the retention mechanism and unit housing may comprise at least one tensioning element for introducing a pre-stress between the retention mechanism and the unit housing. In particular, each tensioning element may be formed by a plastically deformable tab of the frame, which abuts against a surface of the unit housing and thus presses the retention mechanism away from the unit housing. This allows for compensation of manufacturing tolerances by eliminating play between the retention mechanism and the unit housing in their assembled state. These manufacturing tolerances may be inevitable or even necessary for the sake of the above-described latching connections for example.

Alternatively, the retention mechanism may be directly integrated into the receptacle of the unit housing. In particular, the receptacle may be configured for movably guiding the slider. Preferably, the receptacle extends at least partially in the sliding direction. The slider may thus be movably guided in the receptacle. Moreover, the lever may be pivotably held in the receptacle. The position restoration element may be fixedly held in the receptacle, as well. The receptacle may also comprise the at least one guiding slot and/or the at least one fixing hole. Thereby, the frame can be omitted for the purpose of saving costs.

In the following, exemplary embodiments of the invention are described with reference to the drawings. The embodiments shown and described are for explanatory purposes only. The combination of features shown in the embodiments may be changed according to the foregoing description. For example, a feature that is not shown in an embodiment but described above may be added if the technical effect associated with this feature is beneficial for a particular application. Vice versa, a feature shown as part of an embodiment may be omitted as described above, if the technical effect associated with this feature is not needed in a particular application.

In the drawings, elements that correspond to each other with respect to function and/or structure have been provided with the same reference numeral.

In the drawings:
- Fig. 1: shows a schematic representation of an exploded view of a retention mechanism according to one possible embodiment of the present disclosure;
- Fig. 2: shows a schematic representation of a perspective view of the retention mechanism according to another possible embodiment of the present disclosure;
- Fig. 3: shows a schematic representation of a side view of the retention mechanism according to another possible embodiment of the present disclosure;
- Fig. 4: shows a schematic representation of a sectional view of the retention mechanism according to the embodiment shown in Fig. 3; and
- Fig. 5: shows a schematic representation of a detail of a sectional view of a technical equipment unit according to one possible embodiment of the present disclosure.

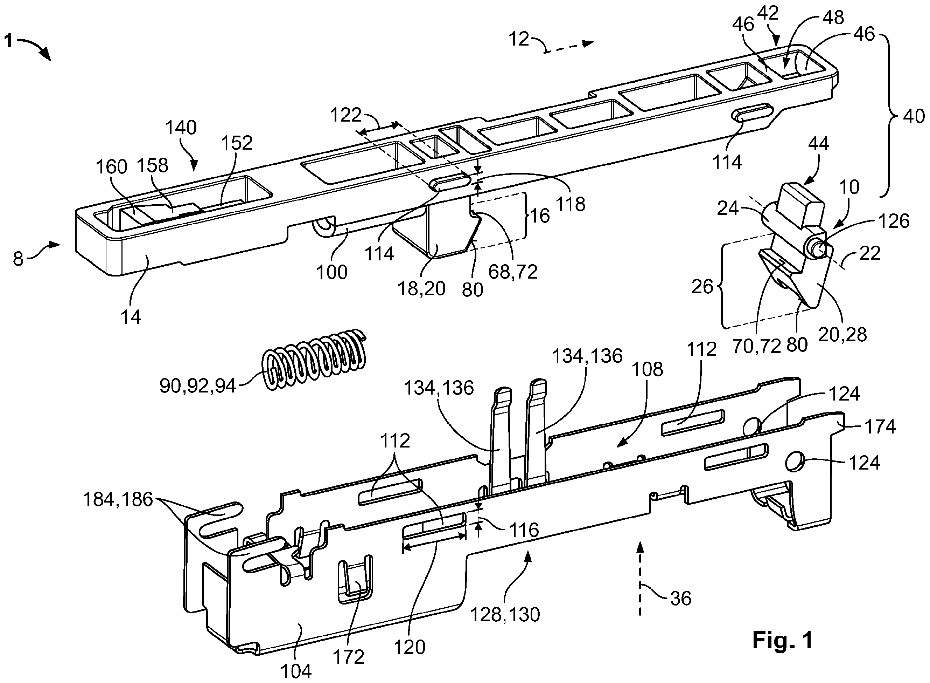

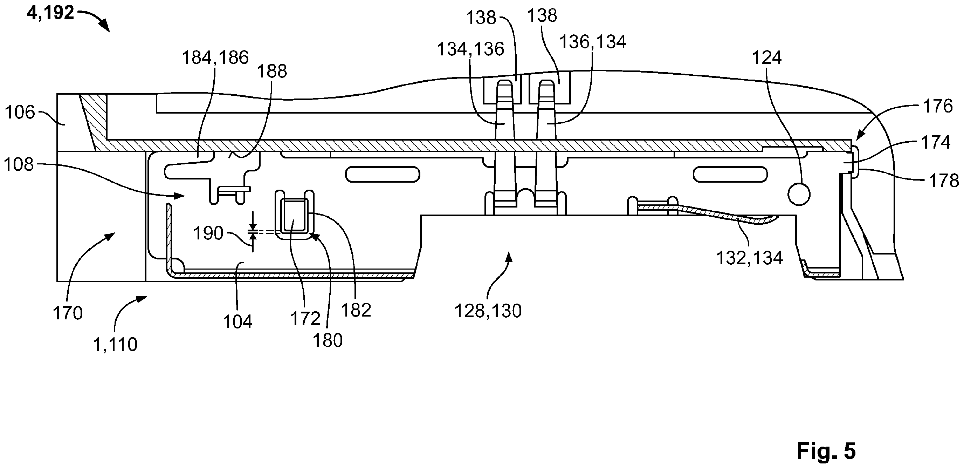

In the following, the structure of possible embodiments of a retention mechanism 1 for attachment of a technical equipment unit 4 to a mounting rail 6 according to the present invention is explained with reference to the exemplary embodiments shown in Figs. 1 to 5. Further, Fig. 5 is used for explaining the structure of a technical equipment unit 4 according to the present invention.

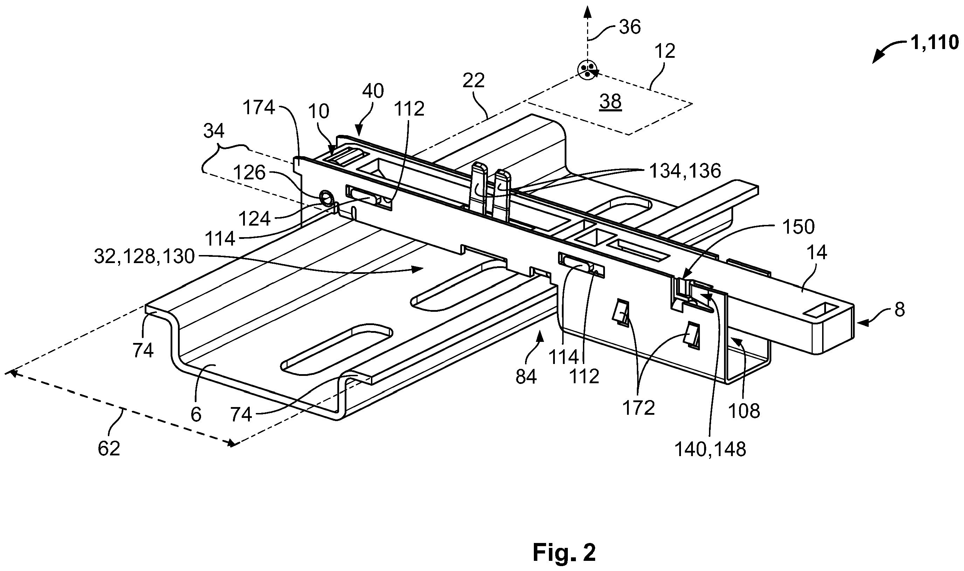

Fig. 1 shows an exploded perspective view of the retention mechanism 1 according to one possible embodiment of the present disclosure. Fig. 2 shows a perspective view of the retention mechanism 1 according to another possible embodiment of the present disclosure attached to the mounting rail 6. As can be seen, the retention mechanism 1 comprises a slider 8 and a lever 10.

The slider 8 is movable in a translational manner along a sliding direction 12. In the shown exemplary embodiment, the slider 8 comprises an oblong, beam-like main body 14 and a first retention section 16. In particular, the main body 14 is oblong with respect to the sliding direction 12. The first retention section 16 is formed by a first hook 18. As can be seen in Fig. 1, the first hook 18 is a hook-shaped projection 20 extending away from the main body 14, preferably perpendicularly to the sliding direction 12.

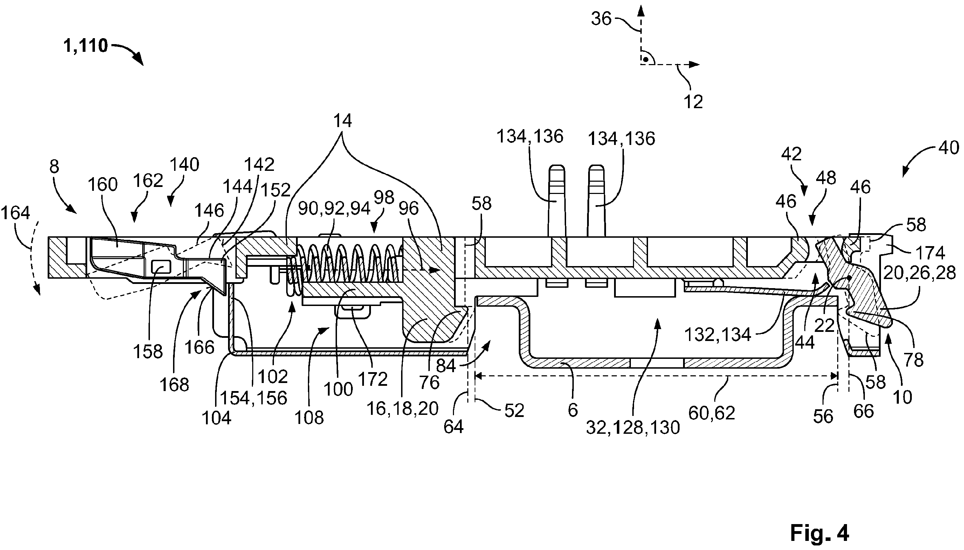

The lever 10 is pivotable about a pivoting axis 22. As will be described in further detail below with reference to Fig. 4, the lever 10 is mechanically coupled with the slider 8. The lever 10 comprises a cylindrical axle 24 and a second retention section 26. The cylindrical axle 24 extends coaxially with the pivoting axis 22. The second retention section 26 is aligned with the first retention section 16 of the slider 8 in the sliding direction 12. Further, the second retention section 26 is formed by a second hook 28. As can be seen in Fig. 1, the second hook 28 is a hook-shaped projection 20 extending away from the cylindrical axle 24, preferably radially away with respect to the pivoting axis 22.

As is shown in Fig. 2, the pivoting axis 22 of the lever 10 may be held fixedly and rotatably within the retention mechanism 1. Further, it is shown that the pivoting axis 22 extends perpendicularly to the sliding direction 12.

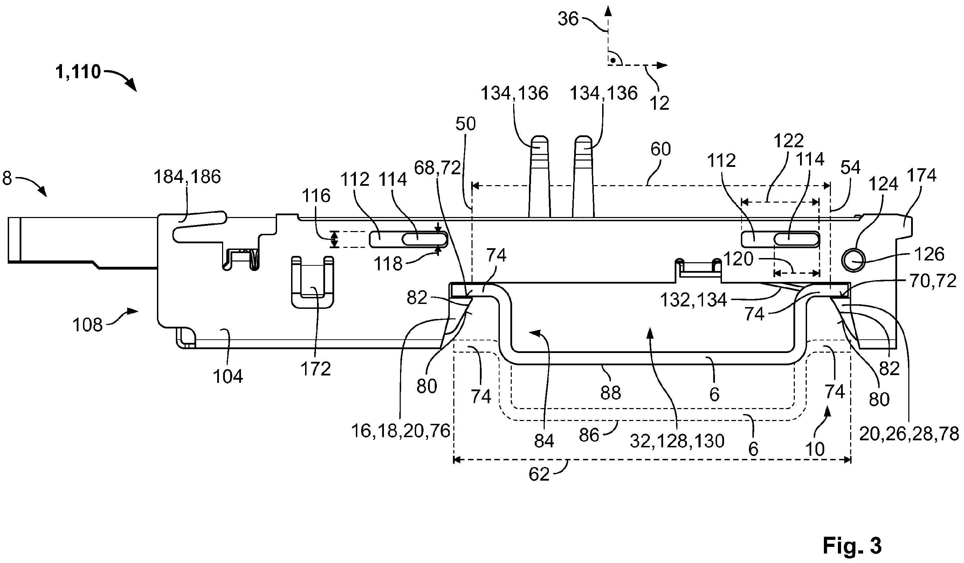

Fig. 3 shows a side view of the retention mechanism 1 according to another possible embodiment of the present disclosure. As can be seen from Figs. 2 and 3, a reception area 32 for receiving a length section 34 of the mounting rail 6 is defined between the first retention section 16 and the second retention section 26. In particular, the reception area 32 is defined between the first hook 18 and the second hook 28.

The reception area 32 may be adapted to receive the mounting rail 6 along a preferential rail mounting direction 36, which is defined with respect to the sliding direction 12 and the direction of the pivoting axis 22. In the shown exemplary embodiments, the rail mounting direction 36 extends linearly i.e., straight, towards a plane 38 spanned by the sliding direction 12 and the pivoting axis 22. In particular, the rail mounting direction 36 is perpendicular to the sliding direction 12 and the pivoting axis 22 (see Fig. 2).

The mounting rail 6 shown exemplarily in Figs. 2 to 4 is a DIN rail with a hat-shaped cross section according to DIN EN 60715. Alternatively, the mounting rail may have a different cross-section and/or comply with a different standard.

Fig. 4 shows a sectional view of the retention mechanism 1. Here it can be seen that the mechanical coupling between the lever 10 and the slider 8 is achieved through a mechanical joint 40. The mechanical joint 40 connects an end section 42 of the slider 8 with an end section 44 of the lever 10. As can be further seen, the respective end sections 42, 44, which are connected by the mechanical joint 40, are distal from the first hook 18 and the second hook 28, respectively.

In particular, the lever 10 may be directly coupled with the slider 8. For this the end section 44 of the lever 10 may be inserted between two inner walls 46 of a cavity 48 formed in the end section 42 of the slider 8. Preferably, the two inner walls 46 may be arranged opposite to each other along the sliding direction 12. The two inner walls 46 may be curved in a circumferential direction with respect to the pivoting axis 22, respectively.

As shown in Figs. 3 and 4, the slider 8 may be movable between a slider locking position 50 (see Fig. 3) and a slider release position 52 (see Fig. 4). Analogously, the lever 10 may be movable between a lever locking position 54 (see Fig. 3) and a lever release position 56 (see Fig. 4). The respective release positions 52, 56 are depicted as dotted lines 58. Due to the mechanical coupling, the lever 10 moves into the lever release position 56 when the slider 8 is moved into the slider release position 52 and vice versa. Also, the lever 10 moves into the lever locking position 54 when the slider 8 is moved into the slider locking position 50 and vice versa.

When the slider 8 and/or lever 10 is in the respective locking position (i.e. slider locking position 50 and/or lever locking position 54), the reception area 32 is narrower, while the reception area 32 is wider, when the slider 8 and/or lever 10 is in the respective release position (i.e. slider release position 52 and/or lever release position 56.

In particular, a clear width 60 of the reception area 32 measured parallel to the sliding direction 12 is smaller than a width 62 of the mounting rail 6, when the slider 8 and/or lever 10 is in the respective locking position 50, 54. The clear width 60 of the reception area 32 is equal to or larger than the width 62 of the mounting rail 6, when the slider 8 and the show lever 10 is in the respective release position 52, 56. This can be seen in Figs. 3 and 4, respectively.

As further shown in Fig. 4, the slider 8 may be moved into a slider end position 64, which is situated away from the slider locking position 50 and beyond the slider release position 52. Analogously, the lever 10 may be moved into a lever end position 66, which is situated away from the lever locking position 54 and beyond the lever release position 56.

The first retention section 16 shown in Fig. 1 comprises a first engagement surface 68 extending in the sliding direction 12 and parallel to the pivoting axis 22. The second retention section 26 may comprise a second engagement surface 70, wherein the first engagement surface 68 and the second engagement surface 70 are mutually coplanar when the slider 8 is in the slider locking position 50 and the lever 10 is in the lever locking position 54, respectively (see Fig. 3). The two coplanar engagement surfaces 68, 70 each provide a resting surface 72 for the mounting rail 6. In Fig. 3, the function of the resting surfaces 72 becomes apparent. Here, outwardly extending flanges 74 of the mounting rail 6 are shown resting on the respective engagement surfaces 68, 70 acting as resting surfaces 72.

Further in Fig. 3, the first retention section 16 comprises a first latching protrusion 76 extending towards the second retention section 26. The second retention section 26 comprises a second latching protrusion 78 extending towards the first retention section 16. The first latching protrusion 76 protrudes into the reception area 32 when the slider 8 is in the slider locking position 50. The second latching protrusion 78 protrudes into the reception area 32 when the lever 10 in the lever locking position 54. The mounting rail 6 is thus gripped by the respective latching protrusions 76, 78, which extend towards each other, when the mounting rail 6 is received in the reception area 32, the slider 8 is in the slider locking position 50 and the lever 10 is in the lever locking position 54.

For release of the mounting rail 6, the slider 8 and/or lever 10 is brought into the respective release position 52, 56. In particular, when the slider 8 is moved into the slider release position 52, the first latching protrusion 76 clears the reception area and is on the verge of protruding into the reception area 32 without actually protruding into the reception area 32. Accordingly, when the lever 10 is moved into the lever release position 56 the second latching protrusion 78 clears the reception area 32 and is on the verge of protruding into the reception area 32 without actually protruding into the reception area 32.

In the shown exemplary embodiments, the first engagement surface 68 is formed on the first latching protrusion 76. The second engagement surface 70 is formed accordingly on the second latching protrusion 78. Further, the first engagement surface 68 and the second engagement surface 70 face in the rail mounting direction 36, when the slider 8 and lever 10 are in their respective locking positions 50, 54.

At least one of the first retention section 16 and the second retention section 26 may comprise a bevel surface 80 extending obliquely with respect to the rail mounting direction 36. In the shown exemplary embodiment of Fig. 3, both the first retention section 16 and the second retention section 26 comprise a bevel surface 80. The bevel surfaces 80 form lead-in chamfers 82, which extend through a peripheral zone 84 of the reception area 32. The bevel surfaces 80 are respectively formed on the first retention section 16 and on the second retention section 26, especially on the first latching protrusion 76 and on the second latching protrusion 78. In particular, the bevel surfaces 80 are respectively aligned with first engagement surface 68 and the second engagement surface 70 in the rail mounting direction 36.

The provision of such bevel surfaces 80 allows the retention mechanism 1 to be attached onto the mounting rail 6 during the attachment process of the technical equipment unit 4. In detail, the technical equipment unit 4 is pushed onto the mounting rail 6 such that the mounting rail 6 enters into to the peripheral zone 84 of the reception area 32. This state is shown in Fig. 3 with the mounting rail 6 drawn in a dotted line 86. By further entering into the reception area 32, the outwardly extending flanges 74 of the mounting rail 6 abut against the bevel surfaces 80 on either side. Upon further entering the reception area 32, the slider 8 and lever 10 are gradually pressed out of their respective locking positions 50, 54 and towards their respective release positions 52, 56 (see Fig. 4). Once the outwardly extending flanges 74 pass beyond the bevel surfaces 80, the slider 8 and lever 10 can return into their respective locking positions 50, 54. This state is shown in Fig. 3 with the mounting rail 6 drawn in a continuous line 88.

Said return of the slider 8 and lever 10 into their respective locking positions 50, 54, is achieved by a position restoration element 90, which exerts a force on at least one of the slider 8 and lever 10. In the shown embodiment of Fig. 1, the position restoration element 90 is a resilient element 92 such as a coil spring 94. The coil spring 94 exerts an elastic force 96 on the slider 8, which acts parallel to the sliding direction 12 by abutting with one end 98 against the slider 8. Optionally, the coil spring 94 may be supported by a coil spring support section 100 of the slider 8 projecting from the first hook 18 and extending along the sliding direction 12 (see Fig. 4).

The respective other end 102 of the coil spring 94 may abut against a frame 104 of the retention mechanism 1, as shown in Fig. 4, or against a unit housing 106 of the technical equipment unit 4.

In the shown exemplary embodiment of Fig. 1, the frame 104 encloses a groove 108 in which the slider 8 is movably guided and the lever 10 is pivotably held. In particular, the retention mechanism 1 comprising the frame 104 represents a preassembled module 110, which can be readily assembled into the unit housing 106 of the technical equipment unit 4, as will be described below.

The frame 104 may comprise at least one guiding slot 112 extending parallel to the groove 108 in the sliding direction 12. For each guiding slot 112, the slider 8 may comprise at least one sliding block 114 projecting into the respective guiding slot 112. A width 116 of the at least one guiding slot 112 measured perpendicular to the sliding direction 12 may be equal to or larger than a width 118 of the corresponding sliding block 114 measured perpendicular to the sliding direction 12. A length 120 of the at least one guiding slot 112 measured parallel to the sliding direction 12 may be larger than a length 122 of the corresponding sliding block 114 measured parallel to the sliding direction 12. As can be seen in Figs. 1 to 3, the frame 104 comprises multiple such guiding slots 112 and the slider 8 comprises multiple sliding blocks 114.

Further, the frame may comprise at least one fixing hole 124 extending parallel to the pivoting axis 22. In the shown embodiment of Fig. 1, the frame 104 comprises two fixing holes 124 on opposite sides of the groove 108. For each fixing hole 124, the lever 10 comprises one axle pin 126 projecting into the respective fixing hole 124. The two axle pins 126 are aligned in the direction of the pivoting axis 22.

In the embodiment shown in Figs. 1 to 5, the frame 104 has a lateral recess 128. The lateral recess 128 is formed by a cut-out 130, which is substantially cuboid. The lateral recess 128 extends along the sliding direction 12 the rail mounting direction 36 and parallel to the pivoting axis 22. Further, the lateral recess 128 extends at least partially into the groove 108 and at least partially coincides with the reception area 32. The lateral recess 128 thus makes the slider 8 and lever 10 accessible for the mounting rail 6.

The frame 104 is electrically conductive. In particular, the frame may be made of metal, such as aluminium, copper or stainless steel. This is the case for the exemplary embodiments shown in Figs. 1 to 5. Further, the frame 104 shown therein comprises at least one first contact point 132 formed by at least one elastic spring finger 134 extending into the lateral recess 128 and reception area 32, respectively. The frame 104 also comprises at least one second contact point 136 formed by at least one elastic spring finger 134 extending away from the lateral recess 128 of the frame 104.

Preferably, the frame 104 comprises multiple parallel elastic spring fingers 134, which form the first contact point 132 and the second contact prongs 134, respectively. The first contact point 132 can be brought into electrical contact with a metallic surface of the mounting rail 6 for grounding purposes. This can be seen in Fig. 4. Also, the second contact point 134 preferably extend inside of the technical equipment unit 4 and electrically contact an electrical component 138, such as a printed circuit board of the technical equipment unit 4. This can be seen in Fig. 5.

The retention mechanism 1 may comprise at least one arresting feature 140 with at least one abutment surface 142 for securing at least one of the slider 8 and lever 10 against movement. The at least one arresting feature 140 may be transferable from a securing state 144 to a disengaging state 146. In particular, the at least one arresting feature 140 may be movable, tiltable, slidable and/or deflectable from the securing state 144 to the disengaging state 146. In the securing state 144, the at least one arresting feature 140 secures the slider 8 and lever 10 against movement. In the disengaging state 146, the at least one arresting feature 140 releases the slider 8 and lever 10 in order to allow their respective movement.

In the shown exemplary embodiment of Fig. 2, the at least one arresting feature 140 is a latch 148 formed on the frame 104. The latch 148 is adapted to engage with the slider 8 by entering into a notch 150 formed on the main body 14 of the slider 8. Thereby, the slider 8 and the lever 10, which is mechanically coupled to the slider 8, are both secured in their respective end positions 64, 66. Alternatively, the slider 8 and lever 10 may be secured in their respective locking positions 50, 54 by the at least one arresting feature 140.

In the embodiment shown in Fig. 4, the at least one arresting feature 140 is formed on the slider 8. In particular, the at least one arresting feature 140 exhibits a shoulder 152, which engages with an edge 154 of a counterpart arresting feature. In this case, the edge 154 of the counterpart arresting feature is a frame edge 156 of the frame 104. The shoulder 152 is monolithically connected to the main body 14 of the slider 8 by a torsion hinge 158. Further, a release button 160 is arranged on an opposite side 162 of the torsion hinge 158. Thus, when the release button 160 is pressed in a circumferential direction 164 with respect to the torsion hinge 158, the shoulder 152 can be leveraged out of alignment with the frame edge 156.

As can further be seen in Fig. 4, a skew surface 166 is provided on the same side 168 of the torsion hinge 158 as the shoulder 152. The skew surface 166 can abut against the frame edge 156 when the slider 8 is moved from the slider locking position 50 (see Fig. 3) to the slider end position 64. During the course of this movement, the abutment between the skew surface 166 and the frame edge 156 leads to the shoulder 152 being gradually leveraged out of alignment with the frame edge 156. This state is shown in Fig. 4 with dotted lines. When the slider8 reaches the slider end position 64, the shoulder 152 is brought back into alignment with the frame edge 156 e.g., due to a bias of the torsion hinge 158. This state is shown in Fig. 4 with continuous lines.

Fig. 5 shows a detail of a sectional view of the technical equipment unit 4. The technical equipment unit 4 may comprise a retention mechanism 1 according to the above description (For the sake of better overview, only the frame 104 of the retention mechanism 1 is shown in Fig. 5) and a unit housing 106, wherein the unit housing 106 has a receptacle 170 for receiving the retention mechanism 1.

The preassembled module 110 described above, may be assembled to the unit housing 106. For this, the frame 104 may comprise a combination of latching features 172 and connectors 174. By means of the connectors 174, connections 176 with counterconnector 178 formed in the receptacle 170 of the unit housing 106 are established, respectively. By means of the latching features 172, latching connections 180 with counterpart latching features 182 formed in the receptacle 170 of the unit housing 106 are established, respectively. This state is shown in Fig. 5.

Further, at least one of the retention mechanism 1 and unit housing 106 may comprise at least one tensioning element 184 for introducing a pre-stress between the retention mechanism 1 and the unit housing 106. In the shown exemplary embodiment of Fig. 5, each tensioning element 184 is formed by a plastically deformable tab 186 of the frame 104, which abuts against a surface 188 of the unit housing 106. The frame 104 comprises two such tabs 186 (see Fig. 1). Due to this abutment, the retention mechanism 1 is pressed away from the unit housing 106. This eliminates play 190 between the retention mechanism 1 and the unit housing 106 e.g, introduced by manufacturing tolerances and/or the latching connections 180.

In the shown embodiment, the technical equipment unit 4 is a PCB module 192 comprising at least one printed circuit board. Alternatively, the technical equipment unit 4 may be a circuit breaker (not shown) or any other type of functional and/or electronics compartment, which requires attachment to the mounting rail 6.

### Reference Signs

- 1: retention mechanism
- 4: technical equipment unit
- 6: mounting rail
- 8: slider
- 10: lever
- 12: sliding direction
- 14: main body
- 16: first retention section
- 18: first hook
- 20: hook-shaped projection
- 22: pivoting axis
- 24: cylindrical axle
- 26: second retention section
- 28: second hook
- 32: reception area
- 34: length section
- 36: rail mounting direction
- 38: plane
- 40: mechanical joint
- 42: end section
- 44: end section
- 46: inner wall
- 48: cavity
- 50: slider locking position
- 52: slider release position
- 54: lever locking position
- 56: lever release position
- 58: dotted line
- 60: clear width
- 62: width
- 64: slider end position
- 66: lever end position
- 68: first engagement surface
- 70: second engagement surface
- 72: resting surface
- 74: outwardly extending flange
- 76: first latching protrusion
- 78: second latching protrusion
- 80: bevel surface
- 82: lead-in chamfer
- 84: peripheral zone
- 86: dotted line
- 88: continuous line
- 90: position restoration element
- 92: resilient element
- 94: coil spring
- 96: elastic force
- 98: end
- 100: coil spring support section
- 102: end
- 104: frame
- 106: unit housing
- 108: groove
- 110: preassembled module
- 112: guiding slot
- 114: sliding block
- 116: width
- 118: width
- 120: length
- 122: length
- 124: fixing hole
- 126: axle pin
- 128: lateral recess
- 130: cut-out
- 132: first contact point
- 134: spring finger
- 136: second contact point
- 138: electrical component
- 140: arresting feature
- 142: abutment surface
- 144: securing state
- 146: disengaging state
- 148: latch
- 150: notch
- 152: shoulder
- 154: edge
- 156: frame edge
- 158: torsion hinge
- 160: release button
- 162: side
- 164: circumferential direction
- 166: skew surface
- 168: side
- 170: receptacle
- 172: latching feature
- 174: connector
- 176: connection
- 178: counterconnector
- 180: latching connection
- 182: counterpart latching feature
- 184: tensioning element
- 186: tab
- 188: surface
- 190: play
- 192: PCB module

## Claims

1. Retention mechanism (1) for attachment of a technical equipment unit (4) to a mounting rail (6), the retention mechanism (1) comprising:
- a slider (8), which is movable in a translational manner along a sliding direction (12),
- a frame (104) enclosing a groove (108) for movably guiding the slider (8) and
- a lever (10), which is pivotable about a pivoting axis (22),
wherein the lever (10) is mechanically coupled with the slider (8), wherein the slider (8) comprises a first retention section (16) and the lever (10) comprises a second retention section (26) aligned with the first retention section (16) in the sliding direction (12), wherein a reception area (32) for receiving the mounting rail (6) is defined between the first retention section (16) and the second retention section (26), **characterized in that** the frame (104) is electrically conductive, and wherein the frame (104) comprises at least one first contact point (132) extending into the reception area (32) and at least one second contact point (136) extending away from the reception area (32).

2. Retention mechanism (1) according to claim 1, wherein the lever (10) is directly coupled with the slider (8).

3. Retention mechanism (1) according to claim 1 or 2, wherein the slider (8) is movable between a slider locking position (50) and a slider release position (52), wherein the lever (10) is movable between a lever locking position (54) and a lever release position (56), and wherein the lever (10) moves into the lever release position (56), when the slider (8) is moved into the slider release position (52).

4. Retention mechanism (1) according to claim 3, wherein the first retention section (16) comprises a first engagement surface (68) extending in the sliding direction (12) and parallel to the pivoting axis (22), wherein the second retention section (26) comprises a second engagement surface (70), and wherein the first engagement surface (68) and the second engagement surface (70) are mutually coplanar, when the slider (8) is in the slider locking position (50) and the lever (10) is in the lever locking position (54).

5. Retention mechanism (1) according to any one of claims 1 to 4, wherein the first retention section (16) comprises a first latching protrusion (76) extending towards the second retention section (26), and wherein the second retention section (26) comprises a second latching protrusion (78) extending towards the first retention section (16).

6. Retention mechanism (1) according to any one of claims 1 to 5, wherein the pivoting axis (22) extends perpendicularly to the sliding direction (12), and wherein the reception area (32) is adapted to receive the mounting rail (6) along a rail mounting direction (36), the rail mounting direction (36) extending linearly towards a plane (38) spanned by the sliding direction (12) and the pivoting axis (22).

7. Retention mechanism (1) according to claim 6, wherein at least one of the first retention section (16) and second retention section (26) comprises a bevel surface (80) extending obliquely with respect to the rail mounting direction (36), and wherein each bevel surface (80) forms a lead-in chamfer (82).

8. Retention mechanism (1) according to any one of claims 1 to 7, wherein the retention mechanism (1) comprises a position restoration element (90), which exerts a force (96) on at least one of the slider (8) and lever (10), the force (96) being directed towards the reception area (32).

9. Retention mechanism (1) according to claim 1, wherein the frame (104) has a lateral recess (128).

10. Retention mechanism (1) according to any one of claims 1 to 9, wherein the retention mechanism (1) comprises at least one arresting feature (140) with at least one abutment surface (142) for securing at least one of the slider (8) and lever (10) against movement.

11. Retention mechanism (1) according to claim 10, wherein the at least one arresting feature (140) is transferable from a securing state (144) to a disengaging state (146).

12. Technical equipment unit (4) comprising a retention mechanism (1) according to any one of claims 1 to 11 and a unit housing (106), wherein the unit housing (106) has a receptacle (170) for receiving the retention mechanism (1).

13. Technical equipment unit (4) according to claim 12, wherein at least one of the retention mechanism (1) and unit housing (106) comprises at least one tensioning element (184) for introducing a pre-stress between the retention mechanism (1) and the unit housing (106).

## Patentansprüche

1. Haltemechanismus (1) zur Befestigung einer technischen Ausrüstungseinheit (4) an einer Tragschiene (6), wobei der Haltemechanismus (1) umfasst:
- einen Schieber (8), der entlang einer Gleitrichtung (12) translatorisch beweglich ist,
- einen Rahmen (104), der eine Nut (108) zur beweglichen Führung des Schiebers (8) umschließt, und
- einem Hebel (10), der um eine Schwenkachse (22) schwenkbar ist,
wobei der Hebel (10) mit dem Schieber (8) mechanisch gekoppelt ist, wobei der Schieber (8) einen ersten Halteabschnitt (16) und der Hebel (10) einen zweiten Halteabschnitt (26) aufweist, der mit dem ersten Halteabschnitt (16) in Gleitrichtung (12) fluchtet, wobei zwischen dem ersten Halteabschnitt (16) und dem zweiten Halteabschnitt (26) ein Aufnahmebereich (32) zur Aufnahme der Tragschiene (6) definiert ist, **dadurch gekennzeichnet, dass** der Rahmen (104) elektrisch leitend ist, und wobei der Rahmen (104) mindestens einen ersten Kontaktpunkt (132) aufweist, der sich in den Aufnahmebereich (32) hinein erstreckt, und mindestens einen zweiten Kontaktpunkt (136), der sich von dem Aufnahmebereich (32) weg erstreckt.

2. Haltemechanismus (1) nach Anspruch 1, wobei der Hebel (10) direkt mit dem Schieber (8) gekoppelt ist.

3. Haltemechanismus (1) nach Anspruch 1 oder 2, wobei der Schieber (8) zwischen einer Schieberverriegelungsstellung (50) und einer Schieberfreigabestellung (52) bewegbar ist, wobei der Hebel (10) zwischen einer Hebelverriegelungsstellung (54) und einer Hebellösestellung (56) bewegbar ist, und wobei sich der Hebel (10) in die Hebellösestellung (56) bewegt, wenn der Schieber (8) in die Schieberfreigabestellung (52) bewegt wird.

4. Haltemechanismus (1) nach Anspruch 3, wobei der erste Halteabschnitt (16) eine erste Eingriffsfläche (68) aufweist, die sich in der Gleitrichtung (12) und parallel zur Schwenkachse (22) erstreckt, wobei der zweite Halteabschnitt (26) eine zweite Eingriffsfläche (70) aufweist, und wobei die erste Eingriffsfläche (68) und die zweite Eingriffsfläche (70) zueinander koplanar sind, wenn der Schieber (8) in der Schieberverriegelungsposition (50) und der Hebel (10) in der Hebelverriegelungsposition (54) ist.

5. Haltemechanismus (1) nach einem der Ansprüche 1 bis 4, wobei der erste Halteabschnitt (16) einen ersten Verriegelungsvorsprung (76) aufweist, der sich zum zweiten Halteabschnitt (26) hin erstreckt, und wobei der zweite Halteabschnitt (26) einen zweiten Verriegelungsvorsprung (78) aufweist, der sich zum ersten Halteabschnitt (16) hin erstreckt.

6. Haltemechanismus (1) nach einem der Ansprüche 1 bis 5, wobei sich die Schwenkachse (22) senkrecht zur Gleitrichtung (12) erstreckt, und wobei der Aufnahmebereich (32) zur Aufnahme der Tragschiene (6) entlang einer Schienenmontagerichtung (36) ausgebildet ist, wobei sich die Schienenmontagerichtung (36) geradlinig zu einer von der Gleitrichtung (12) und der Schwenkachse (22) aufgespannten Ebene (38) erstreckt.

7. Haltemechanismus (1) nach Anspruch 6, wobei mindestens einer der ersten (16) und zweiten (26) Halteabschnitte eine schräg zur Schienenmontagerichtung (36) verlaufende Schrägfläche (80) aufweist, und wobei jede Schrägfläche (80) eine Einlaufschräge (82) bildet.

8. Haltemechanismus (1) nach einem der Ansprüche 1 bis 7, wobei der Haltemechanismus (1) ein Positionsrückstellelement (90) aufweist, das eine Kraft (96) auf den Schieber (8) und/oder den Hebel (10) ausübt, wobei die Kraft (96) auf den Aufnahmebereich (32) gerichtet ist.

9. Haltemechanismus (1) nach Anspruch 1, wobei der Rahmen (104) eine seitliche Aussparung (128) aufweist.

10. Haltemechanismus (1) nach einem der Ansprüche 1 bis 9, wobei der Haltemechanismus (1) mindestens eine Arretiereinrichtung (140) mit mindestens einer Anschlagfläche (142) aufweist, um den Schieber (8) und/oder den Hebel (10) gegen Bewegung zu sichern.

11. Haltemechanismus (1) nach Anspruch 10, wobei die mindestens eine Arretiereinrichtung (140) von einem Sicherungszustand (144) in einen Freigabezustand (146) überführbar ist.

12. Technische Ausrüstungseinheit (4) mit einem Haltemechanismus (1) nach einem der Ansprüche 1 bis 11 und einem Gerätegehäuse (106), wobei das Gerätegehäuse (106) eine Aufnahme (170) zur Aufnahme des Haltemechanismus (1) aufweist.

13. Technische Ausrüstungseinheit (4) nach Anspruch 12, wobei zumindest entweder der Haltemechanismus (1) oder das Gerätegehäuse (106) zumindest ein Spannelement (184) zum Einbringen einer Vorspannung zwischen dem Haltemechanismus (1) und dem Gerätegehäuse (106) aufweist.

## Revendications

1. Mécanisme de retenue (1) pour la fixation d'une unité d'équipement technique (4) sur un rail de montage (6), le mécanisme de retenue (1) comprenant :
- un coulisseau (8), qui est mobile en translation le long d'une direction de coulissement (12),
- un cadre (104) renfermant une rainure (108) pour guider de manière mobile le coulisseau (8) et
- un levier (10), qui peut pivoter autour d'un axe de pivotement (22),
dans lequel le levier (10) est couplé mécaniquement au coulisseau (8), dans lequel le coulisseau (8) comprend une première section de retenue (16) et le levier (10) comprenant une seconde section de retenue (26) alignée avec la première section de retenue (16) dans la direction de coulissement (12), dans lequel une zone de réception (32) pour recevoir le rail de montage (6) est définie entre la première section de retenue (16) et la seconde section de retenue (26), **caractérisé en ce que** le cadre (104) est électriquement conducteur, et dans lequel le cadre (104) comprend au moins un premier point de contact (132) s'étendant dans la zone de réception (32) et au moins un second point de contact (136) s'étendant à l'écart de la zone de réception (32).

2. Mécanisme de retenue (1) selon la revendication 1, dans lequel le levier (10) est directement couplé au coulisseau (8).

3. Mécanisme de retenue (1) selon la revendication 1 ou 2, dans lequel le coulisseau (8) est mobile entre une position de verrouillage de coulisseau (50) et une position de libération de coulisseau (52), dans lequel le levier (10) est mobile entre une position de verrouillage de levier (54) et une position de libération de levier (56), et dans lequel le levier (10) se déplace dans la position de libération de levier (56), lorsque le coulisseau (8) est déplacé dans la position de libération de coulisseau (52).

4. Mécanisme de retenue (1) selon la revendication 3, dans lequel la première section de retenue (16) comprend une première surface d'engagement (68) s'étendant dans la direction de coulissement (12) et parallèlement à l'axe de pivotement (22), dans lequel la seconde section de retenue (26) comprend une seconde surface d'engagement (70), et dans lequel la première surface d'engagement (68) et la seconde surface d'engagement (70) sont mutuellement coplanaires, lorsque le coulisseau (8) est dans la position de verrouillage de coulisseau (50) et le levier (10) est dans la position de verrouillage de levier (54).

5. Mécanisme de retenue (1) selon l'une quelconque des revendications 1 à 4, dans lequel la première section de retenue (16) comprend une première saillie de verrouillage (76) s'étendant vers la seconde section de retenue (26), et dans lequel la seconde section de retenue (26) comprend une seconde saillie de verrouillage (78) s'étendant vers la première section de retenue (16).

6. Mécanisme de retenue (1) selon l'une quelconque des revendications 1 à 5, dans lequel l'axe de pivotement (22) s'étend perpendiculairement à la direction de coulissement (12), et dans lequel la zone de réception (32) est adaptée pour recevoir le rail de montage (6) le long d'une direction de montage de rail (36), la direction de montage de rail (36) s'étendant linéairement vers un plan (38) formé par la direction de coulissement (12) et l'axe de pivotement (22).

7. Mécanisme de retenue (1) selon la revendication 6, dans lequel au moins l'une parmi la première section de retenue (16) et la seconde section de retenue (26) comprend une surface biseautée (80) s'étendant obliquement par rapport à la direction de montage de rail (36), et dans lequel chaque surface biseautée (80) forme un chanfrein d'entrée (82).

8. Mécanisme de retenue (1) selon l'une quelconque des revendications 1 à 7, dans lequel le mécanisme de retenue (1) comprend un élément de restauration de position (90), qui exerce une force (96) sur au moins l'un du coulisseau (8) et du levier (10), la force (96) étant dirigée vers la zone de réception (32).

9. Mécanisme de retenue (1) selon la revendication 1, dans lequel le cadre (104) présente un évidement latéral (128).

10. Mécanisme de retenue (1) selon l'une quelconque des revendications 1 à 9, dans lequel le mécanisme de retenue (1) comprend au moins un élément d'arrêt (140) avec au moins une surface de butée (142) pour fixer au moins l'un du coulisseau (8) et du levier (10) contre tout mouvement.

11. Mécanisme de retenue (1) selon la revendication 10, dans lequel l'au moins un élément d'arrêt (140) est transférable d'un état de fixation (144) à un état de désengagement (146).

12. Unité d'équipement technique (4) comprenant un mécanisme de retenue (1) selon l'une quelconque des revendications 1 à 11 et un boîtier d'unité (106), dans laquelle le boîtier d'unité (106) a un réceptacle (170) pour recevoir le mécanisme de retenue (1).

13. Unité d'équipement technique (4) selon la revendication 12, dans laquelle au moins l'un parmi le mécanisme de retenue (1) et le boîtier d'unité (106) comprend au moins un élément de tension (184) pour introduire une précontrainte entre le mécanisme de retenue (1) et le boîtier d'unité (106).
